# EUROPÄISCHE PATENTSCHRIFT

(11) **EP 1 562 287 B1**
(45) Veröffentlichungstag und Bekanntmachung des Hinweises auf die Patenterteilung: **09.08.2006**
(21) Anmeldenummer: 04030213.5
(22) Anmeldetag: 21.12.2004
(51) Int. Cl.: H03F 3/60, H03F 3/21

(54) **Verfahren und Schaltung zum Phasenabgleich von Verstärkermodulen**
Method and circuit for phase alignment of amplifier modules
Méthode et circuit pour l'alignement de phase des modules d'amplificateur

(30) Priorität: 07.02.2004 DE 102004006070
(43) Veröffentlichungstag der Anmeldung: 10.08.2005
(73) Patentinhaber: EADS Deutschland GmbH, 85521 Ottobrunn (DE)
(72) Erfinder: Hoffmann, Gebhard, Dr., 80805 München (DE); Salomon, Andreas, 81549 München (DE)
(74) Vertreter: Meel, Thomas

(56) Entgegenhaltungen:
- WO-A-01/06643

## Beschreibung

Die Erfindung betrifft ein Verfahren zum Abgleichen von Phasen von Verstärkermodulen gemäß dem Oberbegriff des Patentanspruchs 1, sowie eine Schaltung gemäß dem Oberbegriff des Patentanspruchs 5.

Es ist bekannt, dass wenn die Ausgangsleistung mehrerer parallel geschalteter Verstärkermodule, z.B. in einem Wilkinson-Summierer, kombiniert werden soll, dass zuvor die Phase der Verstärkeransteuerung abgeglichen werden muß. Nur bei abgeglichener Phase ist die Gesamtausgangsleistung die Summe der Einzelleistungen. Es ist Stand der Technik, den Phasenabgleich derart durchzuführen, dass die mehreren Verstärkermodule auf ein Referenzverstärkermodul abgeglichen werden. Der Abgleich erfolgt dabei derart, dass die Verstärkermodule entsprechend eines Musters (Referenzverstärkermodul) hergestellt wurden. Die Ausgangsphasen der einzelnen Verstärkermodule werden bei der Herstellung mittels baulicher Maßnahmen nahezu angeglichen.
Ein Nachteil dieses Verfahrens ist, dass in der Serienproduktion von Bauteilen mit mehreren parallel geschalteten Verstärkermodulen ein erhöhter Abgleichaufwand nötig ist. Ein weiterer Nachteil ist, dass Phasenfehler, welche z.B. aufgrund von Temperaturveränderungen oder Alterung auftreten, nicht ausgeglichen werden können.

Es ist somit Aufgabe der Erfindung, ein Verfahren anzugeben, mit dem für mehrere parallel geschaltete Verstärkermodule ein einfacher Phasenabgleich möglich ist. Eine weitere Aufgabe besteht darin, eine Schaltung zur Durchführung des Verfahrens anzugeben.

Ein Verfahren sowie eine Schaltung zum Abgleichen der Phasen einer Anzahl n von Verstärkermodulen, ist aus dem Dokument WO 01/06643 A (QUALCOMM INCORPORATED) 25. Januar 2001 (2001-01-25) bekannt. Hierbei werden die n Verstärkermodule jeweils mit einer Phase eingestellt, die gleich der Phase des Summensignals der kombinierten übrigen n-1 Verstärkermodule ist, wobei auf das Leistungsmaximum abgeglichen wird.

Erfindungsgemäss werden die obengenannten Aufgaben mit dem Verfahren gemäss Patentanspruch 1 und mit einer Schaltung gemäß Patentanspruch 5 gelöst. Vorteilhafte Ausführungen der Erfindung sind Gegenstand von Unteransprüchen.

Erfindungsgemäß wird in einem ersten Schritt ein Verstärkermodul als Referenzmodul mit einer festen Phase bestimmt. In einem zweiten und in weiteren Schritten werden die Phasen der anderen Verstärkermodule jeweils paarweise mit dem im ersten Schritt bestimmten Referenzmodul derart eingestellt, dass die kombinierte Ausgangsleistung aus dem jeweiligen einzelnen Verstärkermodul und dem Referenzmodul minimal wird. In einem letzten Schritt wird die Phase des Referenzmoduls um 180° gedreht.

Eine erfindungsgemäße Schaltung zum Abgleichen der Phasen einer Anzahl von Verstärkermodulen umfaßt eine Signalquelle, welche jeder Verstärkerstufe zugeordnet ist. Vorteilhaft ist eine mit der Signalquelle verbundene digitale Schnittstelle vorhanden.

Ein Vorteil des erfindungsgemäßen Verfahrens ist, dass bei der Fertigung kein Phasenabgleich der Verstärkermodule auf ein separates musterhaftes Referenzmodul nötig ist. Die Verstärkermodule können zweckmäßig Sendermodule in einem Antennensystem sein.

Ein weiterer Vorteil ist, dass der Phasenabgleich im Wesentlichen automatisch erfolgen kann. Darüber hinaus kann mit dem erfindungsgemäßen Verfahren eine Kompensation von Phasenabweichungen erreicht werden, welche z.B. aufgrund von Temperaturveränderungen oder durch Alterung oder Tausch eines Verstärkermoduls entstehen. Ein weiterer Vorteil ist, dass der Phasenabgleich im laufenden Betrieb der Verstärkermodule erfolgen kann.
Ein weiterer Vorteil des erfindungsgemäßen Verfahrens ist, dass das Ergebnis des Phasenabgleichs unabhängig von dem im ersten Verfahrensschritt ausgewählten Referenzmoduls ist.

In einer vorteilhaften Ausführung der Erfindung werden vor einem Phasenabgleich zwischen dem Referenzmodul und einem Verstärkermodul die übrigen Verstärkermodule ausgeschaltet. Dadurch wird eine optimale Abstimmung der Phasen zwischen den beiden Modulen erreicht.

In einer weiteren vorteilhaften Ausführung der Erfindung wird die Phase für jedes Verstärkermodul digital erzeugt und eingestellt. Dadurch sind gegenüber einer analogen Erzeugung genauere Phasenwerte einstellbar. Außerdem können die Phasenwerte digital wesentlich schneller eingestellt werden, wodurch der gesamte Phasenabgleich schneller erfolgen kann.

Vorteilhaft wird der Phasenwert, bei dem die kombinierte Ausgangsleistung aus dem jeweiligen einzelnen Verstärkermodul und dem Referenzmodul minimal ist, gespeichert. Dadurch ist es möglich, dass bei einem Systemneustart der Verstärkermodule die Phasenwerte wieder in die Verstärkermodule geschrieben werden können. Selbstverständlich kann der Phasenwert auch in die der Verstärkerstufe zugeordnete Signalquelle geschrieben werden.

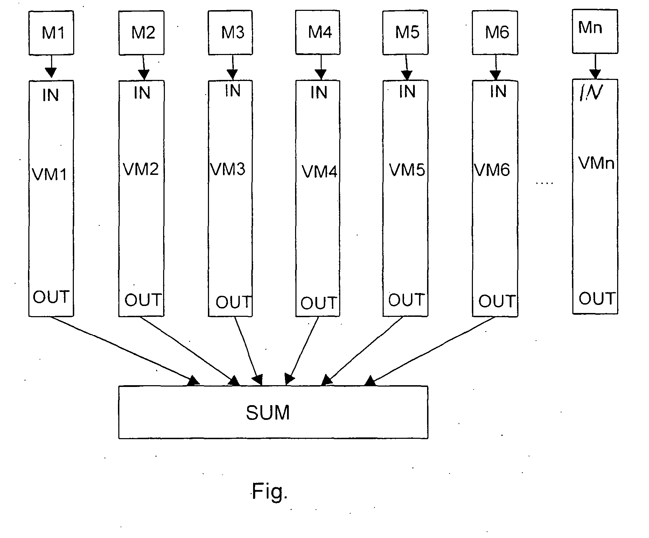

In der einzigen Figur ist eine erfindungsgemäße Schaltung dargestellt.

Jedem Verstärkermodul VM1-VMn ist eine Signalquelle M1-Mn zugeordnet, wobei die Signalquelle M1-Mn jeweils mit dem Eingang IN des Verstärkermoduls VM1-VMn verbunden ist. Die Ausgänge OUT der Verstärkermodule VM1-VM6 sind mit einem Summierer SUM verbunden. In dem Summierer SUM werden die Ausgangsleistungen der einzelnen Verstärkermodule VM1-VM6 kombiniert.

Im weiteren wird das Verfahren zum Phasenabgleich detailliert beschrieben. Erfindungsgemäß werden die Verstärkermodule pärchenweise abgeglichen, wobei beim Abgleich bis auf die zwei abzugleichenden Module alle übrigen Module abgeschaltet sind.
Die Phase eines beliebigen Verstärkermoduls, im weiteren als Referenzmodul bezeichnet, wird initialisiert und während der Abgleichprozedur konstant gehalten. Die übrigen Module werden einzeln und zweckmäßig der Reihe nach hinzugeschaltet.

Ein beispielhafter Ablauf für einen Abgleich bei 6 Verstärkermodulen ist in folgender Tabelle dargestellt. In diesem Beispiel ist das Verstärkermodul VM1 als Referenzmodul ausgewählt.

| | VM1 | VM2 | VM3 | VM4 | VM5 | VM6 |
|---|---|---|---|---|---|---|
| 1. Schritt | ein | ein | x | x | x | x |
| 2. Schritt | ein | x | ein | x | x | x |
| 3. Schritt | ein | x | x | ein | x | x |
| 4. Schritt | ein | x | x | x | ein | x |
| 5. Schritt | ein | x | x | x | x | ein |

Die Phase des jeweils zweiten Verstärkermoduls VM2-VM6 wird von Null an erhöht, bis am Ausgang des Summierers ein Leistungsminimum der Ausgangsleistung gemessen wird. Der zugehörige Phasenwert des entsprechenden Verstärkermoduls VM2-VM6 wird gespeichert (nicht dargestellt).
Der Abgleich auf das Leistungsminimum ist günstiger als ein Abgleich auf das Leistungsmaximum, da das Minimum über die Phaseneinstellung deutlich schärfer ausgeprägt ist. Nach Abschluß des Phasenabgleichs, d.h. alle Verstärkermodule VM2-VM6 wurden mit dem Referenzmodul VM1 abgeglichen, wird die Phase des als Referenzmoduls festgelegten Verstärkermoduls VM1 um 180° gedreht. Anschließend werden alle Verstärkermodule aktiviert.

Das erfindungsgemäße Verfahren ist anwendbar in Antennensystemen mit ein oder mehreren Sendern.

## Patentansprüche

1. Verfahren zum Abgleichen der Phasen einer Anzahl von Verstärkermodulen (VM1,...,VMn) mittels eines Referenzmoduls (VM1) zur Maximierung der kombinierten Ausgangsleistung der Verstärkermodule (VM1,...,VMn), **dadurch gekennzeichnet, dass** in einem ersten Schritt ein Verstärkermodul (VM1) als Referenzmodul mit einer festen Phase bestimmt wird, dass in einem zweiten und in weiteren Schritten die Phasen der anderen Verstärkermodule (VM2,...,VMn) jeweils paarweise mit dem im ersten Schritt bestimmten Referenzmodul (VM1) derart eingestellt werden, dass die kombinierte Ausgangsleistung aus dem jeweiligen einzelnen Verstärkermodul (VM2,...,VMn) und dem Referenzmodul (VM1) minimal wird und dass in einem letzten Schritt die Phase des Referenzmoduls (VM1) um 180° gedreht wird.

2. Verfahren nach Anspruch 1, **dadurch gekennzeichnet, dass** vor einem Phasenabgleich zwischen dem Referenzmodul (VM1) und einem Verstärkermodul (VM2,...,VMn) die übrigen Verstärkermodule ausgeschaltet werden.

3. Verfahren nach einem der vorangehenden Ansprüche, **dadurch gekennzeichnet, dass** die Phase für jedes Verstärkermodul (VM1,...,VMn) digital erzeugt und eingestellt wird.

4. Verfahren nach einem der vorangehenden Ansprüche, **dadurch gekennzeichnet, dass** der Phasenwert, bei dem die kombinierte Ausgangsleistung aus dem jeweiligen einzelnen Verstärkermodul (VM2,...,VMn) und dem Referenzmodul (VM1) minimal ist, gespeichert wird.

5. Schaltung zum Abgleichen der Phasen einer Anzahl von Verstärkermodulen (VM1 ,...,VMn) nach einem Verfahren gemäß einem der vorangehenden Ansprüche, **dadurch gekennzeichnet, dass** jedem Verstärkermodul (VM1, ..., VMn) eine Signalquelle (M1,...,Mn) mit einer einstellbaren Phase zugeordnet ist.

6. Schaltung nach Anspruch 5, **dadurch gekennzeichnet, dass** eine mit der Signalquelle (M1,...,Mn) verbundene digitale Schnittstelle vorhanden ist.

## Claims

1. Method for adjustment of the phases of a number of amplifier modules (VM1, ..., VMn) by means of a reference module (VM1) in order to maximize the combined output power of the amplifier module (VM1, ..., VMn), **characterized in that** in a first step, one amplifier module (VM1) is defined as reference module with a fixed phase, **in that**, in a second and in further steps, the phases of the other amplifier modules (VM2, ..., VMn) are each set in pairs using the reference module (VM1) defined in the first step, in such a manner that the combined output power of each individual amplifier module (VM2, ..., VMn) and the reference module (VM1) is a minimum, and **in that** the phase of the reference module (VM1) is shifted through 180° in a final step.

2. Method according to Claim 1, **characterized in that** the other amplifier modules are switched off before phase adjustment, between the reference module (VM1) and an amplifier module (VM2, ..., VMn).

3. Method according to one of the preceding claims, **characterized in that** the phase of each amplifier module (VM1, ..., VMn) is produced and set digitally.

4. Method according to one of the preceding claims, **characterized in that** the phase value for which the combined output power from each individual amplifier module (VM2, ..., VMn) and the reference module (VM1) is a minimum is stored.

5. Circuit for adjustment of the phases of a number of amplifier modules (VM1, ..., VMn) using a method according to one of the preceding claims, **characterized in that** each amplifier module (VM1, ..., VMn) has an associated variable-phase signal source (M1, ..., Mn).

6. Circuit according to Claim 5, **characterized in that** a digital interface which is connected to the signal source (M1, ..., Mn) is provided.

## Revendications

1. Procédé d'ajustement des phases d'un nombre de modules amplificateurs (VM1, ..., VMn) au moyen d'un module de référence (VM1) afin de maximiser la puissance combinée de sortie des modules (VM1, ..., VMn), **caractérisé en ce que** dans une première étape un module amplificateur (VM1) est déterminé comme module de référence ayant une phase fixe, **en ce que** dans une deuxième et d'autres étapes les phases des autres modules amplificateurs (VM2,...,VMn) sont chacune réglées par paires avec le module amplificateur déterminé à la première étape (VM1) de façon à ce que la puissance combinée de sortie provenant du module amplificateur individuel respectif (VM2,...,VMn) et du module de référence (VM1) devienne minimale et à ce que dans une dernière étape la phase du module de référence (VM1) soit tournée de 180°.

2. Procédé selon la revendication 1, **caractérisé en ce qu'**avant un ajustement de phase entre le module de référence (VM1) et un module amplificateur (VM2,...,VMn), les modules amplificateurs restants sont mis hors service.

3. Procédé selon l'une quelconque des revendications précédentes, **caractérisé en ce que** la phase pour chaque module amplificateur (VM1,...,VMn) est produite et réglée par voie numérique.

4. Procédé selon l'une quelconque des revendications précédentes, **caractérisé en ce que** la valeur de phase pour laquelle la puissance combinée de sortie provenant du module amplificateur individuel respectif (VM2,...,VMn) et du module de référence (VM1) est minimale, est mémorisée.

5. Circuit d'ajustement des phases d'un nombre de modules amplificateurs (VM1,..., VMn) selon un procédé selon l'une quelconque des revendications précédentes, **caractérisé en ce qu'**à chaque module amplificateur (VM1,...,VMn) est associée une source de signaux (M1,...,Mn) avec une phase réglable.

6. Circuit selon la revendication 5, **caractérisé en ce qu'**une interface numérique connectée à la source de signaux (M1,..., Mn) est présente.
